# NEUE EUROPÄISCHE PATENTSCHRIFT

(11) **EP 1 624 081 B2**
(45) Veröffentlichungstag und Bekanntmachung des Hinweises auf die Entscheidung über den Einspruch: **08.09.2010**
(45) Hinweis auf die Patenterteilung: 23.08.2006
(21) Anmeldenummer: 05016062.1
(22) Anmeldetag: 25.07.2005
(51) Int. Cl.: C22C 21/00, B32B 15/01, F16C 33/12

(54) **Aluminiumlegierung für tribologisch beanspruchte Flächen**
Aluminium alloy for tribologically stressed surfaces
Alliage d'aluminium pour surfaces chargées tribologiquement

(30) Priorität: 03.08.2004 AT 13292004
(43) Veröffentlichungstag der Anmeldung: 08.02.2006
(73) Patentinhaber: Miba Gleitlager GmbH, 4663 Laakirchen (AT)
(72) Erfinder: Mergen, Robert, Dipl.-Ing. Dr., 4813 Altmünster (AT); Gärtner, Walter, Dr., 4810 Gmunden (AT)
(74) Vertreter: Ofner, Clemens

(56) Entgegenhaltungen:
- EP-A- 1 475 449
- EP-B- 0 265 937
- DE-A1- 4 026 907
- DE-C- 2 853 724
- US-A- 4 471 032

## Beschreibung

Die Erfindung betrifft eine Aluminiumlegierung für eine Beschichtung für tribologisch beanspruchte Flächen, mit einer Aluminiummatrix in der zumindest eine Weichphase und Hartphase eingelagert ist, wobei die Hartphase durch zumindest ein Element aus einer ersten Elementgruppe umfassend Chrom, Eisen, Kobalt, Kupfer, Mangan, Nickel, Molybdän, Magnesium, Niob, Platin, Scandium, Silber, Silizium, Vanadium, Wolfram, Zirkonium und/oder Carbide, Silicide, Nitride, Boride der Elemente der ersten Elementgruppe bzw. durch intermetallische Phasen aus Elementen der ersten Elementgruppe und/oder durch intermetallische Phasen aus Aluminium mit den Elementen aus der ersten Elementgruppe, und die Weichphase durch zumindest ein Element aus einer zweiten Elementgruppe, umfassend Silber, Aluminium, Gold, Bismut, Kohlenstoff (Graphit), Kalzium, Kupfer, Indium, Magnesium, Blei, Palladium, Platin, Scandium, Zinn, Yttrium, Zink und die Lanthanoide gebildet ist, wobei das Weichphasenelement ungleich dem Hartphasenelement ist, eine Beschichtung, insbesondere für Gleitelemente, aus einer Aluminiumlegierung, einen Verbundwerkstoff aus zumindest einem Träger und einer darauf angeordneten Randschicht, ein Verfahren zur Herstellung eines Verbundwerkstoffes aus zumindest einem Träger und einer darauf angeordneten Randschicht sowie die Verwendung der Aluminiumlegierung zur Herstellung einer Gleitschicht für Gleitelemente bzw. zur Beschichtung von tribologisch beanspruchten Bauteilen.

Beschichtungen tribologisch beanspruchter Bauteile bzw. Flächen sollen verschiedensten Anforderungen genügen. Zum einen wird eine möglichst reibungsarme Beschichtung gewünscht, welche relativ weich ist und sich dem zufolge gut an einen verschleißbedingten Abrieb sowie den Gleitpartner anpassen kann. Andererseits muss eine genügend hohe mechanische Stabilität und Festigkeit gegeben sein, um neben den statischen auch dynamische Schwingungsbelastungen aufnehmen zu können und somit die Dauerfestigkeit und die Lebensdauer zu steigern. Die Entwicklungen, beispielsweise in der Motorenindustrie, gehen in Richtung höherer spezifischer Leistungen, um insbesondere in Hinblick auf immer strenger werdende Abgasnormen den Wirkungsgrad und damit die Wirtschaftlichkeit und die Umweltverträglichkeit von Verbrennungskraftmaschinen zu erhöhen. Von dieser Entwicklung sind eine Vielzahl von Komponenten eines Verbrennungsmotors betroffen, wie beispielsweise die durch die sehr hohen Drehmomente und die zur Optimierung des Verbrennungsprozesses stetig steigenden Zünddrücke, beispielsweise eines direkteinspritzenden Turbodieselmotors, sehr hoch belasteten Radialgleitlager. Diesen Belastungen sind Standardgleitlager nicht gewachsen. Durch die leistungsfähigen Einspritzsysteme dieser Motoren werden ebenso die Komponenten der Einspritzpumpen und deren Messinstrumente bzw. durch die höheren Leistungen auch andere Bauteile, wie Stößel, Stiften oder Rollen, welche gleitbeansprucht werden, diesen hohen Belastungen ausgesetzt. Häufig werden Aluminiumlegierungen für diese Komponenten eingesetzt, da damit grundsätzlich ein gutes Verhältnis zwischen erzielbaren Eigenschaften und aufzuwendenden Kosten erreicht werden kann.

Die DE 36 31 029 C2 beschreibt eine zinnhaltige Aluminiumlagerlegierung und deren Verwendung für einen Zweischichtlagerwerkstoff. Durch die Zugabe von unter anderem Zinn, Silizium und Blei entsteht ein Gefüge aus in der Aluminiummatrix abgeschiedenen Zinn- und Bleilegierungsteilchen, welche benachbart zu Siliziumteilchen abgeschieden sind. Dadurch soll das Lagermaterial verbesserte Eigenschaften, wie beispielsweise eine höhere Ermüdungsbeständigkeit und höhere Sicherheit gegen Fressen aufweisen.

Die DE 101 35 895 A1 beschreibt eine Aluminiumlegierung, welche Aluminium- Silizium-Eisen- Ternärelementzwischenmetallverbindungen und Siliziumpartikel als harte Partikel enthält. Dadurch werden die Antiblockiereigenschaften verbessert, ohne die Ermüdungsbeständigkeit zu verringern.

Die US 4,471,029 A beschreibt eine Aluminiumbasislegierung, welche als Legierungselemente Silizium sowie Zinn enthält, wobei eine Mehrheit von Siliziumpartikel einen Durchmesser > 5µm aufweist. Dadurch soll die Ermüdungsfestigkeit bzw. Verschleißbeständigkeit erhöht werden.

Die DE 43 12 537 C2 beschreibt ein Mehrschichtlager aus Aluminiumlegierungen mit einer Stütz-, Zwischen- und Lagerschicht, wobei die Lagerschicht aus einer Aluminiumlegierung mit Zinn-Silizium gebildet ist, die eine Vickershärte von <50 aufweist. Dadurch soll eine hohe Verträglichkeit bzw. Toleranz wie auch eine hohe Ermüdungsbeständigkeit erreicht werden.

Das Dokument DE-A-40 26 907 offenbart einen Lagerwerkstoff, der aus einer Matrix aus einer Metall-Legierung wie z.B. Aluminium, die mit Pb-Basis-Werkstoffen ein monotektisches System bildet, und darin derart dispergierten, im wesentlichen kugelförmigen Weichphasen aus einem Pb-Basis-Wersktoff, dass die Konzentration der Weichphasen in der Matrix zu einer Oberfläche des Lagerwerkstoffes hin zunimmt, besteht. Der aus DE-A-40 26 907 bekannte Lagerwerkstoff enthält zusätzlich Hartstoffpartikel wie Metalloxide, Metallnitride, Metallcarbide, Metalloxycarbide, Metalloxynitride oder Silicate.

Der Erfindung liegt die Aufgabe zugrunde, eine Aluminiumlegierung mit verbesserten tribologischen Eigenschaften zur Verfügung zu stellen.

Diese Aufgabe der Erfindung wird jeweils eigenständig durch eine eingangs genannte Aluminiumlegierung, bei der die Weichphase und/oder die Hartphase in der Aluminiummatrix im wesentlichen fein verteilt vorliegt und zumindest 80 %, vorzugsweise zumindest 90 %, der Weichphase bzw. der Weichphasenpartikel einen mittleren Durchmesser von maximal 3 µm aufweist und dass zumindest 90% der Hartphasen bzw. Hartphasenpartikel einen geringeren mittleren Durchmesser als die Weichphasenpartikel aufweisen, wobei der mittlere Durchmesser der Hartphase bzw. Hartphasenpartikel maximal 50% des mittleren Durchmessers der Weichphase bzw. Weichphasenpartikel beträgt sowie einer daraus gebildeten Beschichtung, einen Verbundwerkstoff, umfassend eine aus der erfindungsgemäßen Beschichtung gebildeten Randschicht sowie einem eingangs genannten Verfahren, bei dem durch ein Abscheiden aus einer Gasphase auf dem Träger als Randschicht eine erfindungsgemäße Aluminiumlegierung hergestellt wird, gelöst. Von Vorteil ist dabei, dass es nunmehr möglich ist, eine Aluminiumlegierung bereitzustellen, deren Gefüge es ermöglicht, dass das damit beschichtete Bauteil eine hohe tribologische Verträglichkeit aufweist und trotzdem eine hohe mechanische Belastbarkeit bezüglich statischen und dynamischen Einwirkungen gegeben ist. Die Weichphasenpartikel weisen einen sehr geringen mittleren Durchmesser aufweisen und liegen fein verteilt in der Aluminiummatrix vor. Diese feine Verteilung erschwert durch die veränderte Gefügestruktur die Ausbildung eines zusammenhängenden Weichphasennetzes, welches die strukturelle Festigkeit der aus der Legierung gebildeten Beschichtung negativ beeinflussen würde. Zudem ist eine hohe Beständigkeit gegenüber fressendem Verschleiß bzw. die tribologische Verträglichkeit und die Einbettbarkeit in hohem Maße gegeben. Bei Aluminiumlegierungen nach dem Stand der Technik wurden diese Eigenschaften bisher nur mit sich stark verschlechternden mechanischen Eigenschaften bzw. sinkender Festigkeit erreicht. Die feine Verteilung und geringe Größe der Weichphasenelemente verhindert eine Schwächung der Aluminiummatrix, wodurch die Wirkung von festigkeitssteigernden Hartphasen erst im vollen Umfang zum tragen kommen kann. Durch die geringe Anzahl von Weichphasenpartikeln, welche einen mittleren Durchmesser größer als 3 µm aufweisen, werden beispielsweise die strukturelle Festigkeit oder die Gleiteigenschaften der Beschichtung nicht negativ beeinflusst. Dadurch, dass die erfindungsgemäße Beschichtung durch Abscheiden aus einer Gasphase hergestellt wird, wird ohne eine aufwendige und damit kostenintensive Nachbehandlung des mit der erfindungsgemäßen Aluminiumlegierung beschichteten Bauteils eine feindisperse Verteilung der Hart- bzw. Weichphasen bei gleichzeitig geringer mittlerer Korngröße erreicht und ist eine Zugabe von Elementen, wie beispielsweise Strontium, zur Verbesserung der Dispersion, wie nach dem Stand der Technik bekannt, nicht erforderlich. Durch die ebenso erreichte nahezu kugelförmige Gestalt bzw. durch eine Form ohne scharfkantige Nadeln oder Spieße, werden die Eigenschaften gegenüber Fressen verbessert und wird zudem die Zähigkeit der Aluminiummatrix neben deren Zugfestigkeit und Bruchdehnung erhöht. Insgesamt ist die Verreibgrenzlast gegenüber Standardlagern erhöht und ergeben sich ebenso eine erhöhte Verschleißfestigkeit, auch bei hohen Lagerlasten sowie eine sehr hohe Kavitationsbeständigkeit. Weiters wird das Auftragen der erfindungsgemäßen Beschichtung auf geometrisch einfache Körper, wie beispielsweise Gleitlager, gegenüber herkömmlichen Methoden wie Plattieren von gegossenen und gewalzten Bändern, vereinfacht. Auch auf geometrisch komplizierte Bauteile oder Strukturen lässt sich die Beschichtung in einfacher Weise aufbringen. Des weiteren lassen sich auch sehr kleine Strukturen zuverlässig beschichten. Auch ist die Herstellung mehrlagiger Schichten ohne erheblichen Aufwand möglich. Es ergeben sich insgesamt sehr gute Schichteigenschaften und lässt sich auch die Schichtdicke sehr genau an die Erfordernisse anpassen.

Gemäß Weiterbildungen der Aluminiumlegierung, wonach die Weichphasen bzw. die Weichphasenpartikel einen mittleren Durchmesser von maximal 2 µm, insbesondere maximal 1µm, aufweisen bzw. wonach die Weichphasen bzw. die Weichphasenpartikel einen mittleren Durchmesser im Bereich von 200 nm bis 700 nm, insbesondere im Bereich von 350 nm bis 550 nm, aufweisen, wird in vorteilhafter Weise erreicht, dass die gute tribologische Verträglichkeit der Beschichtung weiter gesteigert werden kann und trotzdem eine hohe Festigkeit erhalten bleibt.

Dadurch, dass zumindest 95 %, der Hartphasen bzw. der Hartphasenpartikel einen geringeren mittleren Durchmesser als die Weichphasenpartikel aufweisen wird eine hohe Festigkeit der Beschichtung erreicht, da durch die gleichmäßige, feine Verteilung der Hartphasenpartikel eine lokale Schwächung der Aluminiummatrix durch große Agglomerate verhindert wird.

Dadurch, dass der mittlere Durchmesser der Hartphasen bzw. Hartphasenpartikel maximal 25 %, des mittleren Durchmessers der Weichphasen bzw. Weichphasenpartikel beträgt, kann durch die dabei erzielten weiteren Verbesserungen der mechanischen Eigenschaften der Legierung eine längere Lebensdauer bzw. eine höhere Belastung des Lagers erreicht werden.

Gemäß einer Weiterbildung, wonach der Anteil der Weichphase im Bereich zwischen 15 Gew.-% und 45 Gew.-%, bevorzugt im Bereich zwischen 20 Gew.-% und 40 Gew.-%, beträgt wird der Vorteil erzielt, dass im Betrieb gute Gleiteigenschaften und eine hohe Anpassungsfähigkeit an den Gleitpartner in der Einlaufphase erreicht wird. Zudem weist die Legierung bzw. eine Beschichtung aus der Legierung hohe Notlaufeigenschaften auf, wodurch die Lebensdauer beispielsweise von Gleitlagern stark ansteigt.

Gemäß einer Variante, wonach der Anteil der Weichphase im Bereich zwischen 23 Gew.-% und 28 Gew.-% beträgt, lassen sich die Eigenschaften hinsichtlich der Anpassungsfähigkeit bzw. der Gleiteigenschaften optimieren und wird ein gutes Verhältnis von tribologischer Eigenschaft zu erzielbarer Festigkeit beibehalten.

Gemäß Weiterbildungen ist es möglich, dass der Anteil der Hartphase im Bereich zwischen 1,5 Gew.-% und 40 Gew.-%, bzw. im Bereich zwischen 2 Gew.-% und 20 Gew.-%, insbesondere im Bereich zwischen 2,5 Gew.-% und 17 Gew.-%, beträgt. Dadurch ergibt sich der Vorteil, dass sich die mechanischen Eigenschaften der Legierung bzw. der Beschichtung in einem weiten Bereich an die Erfordernisse anpassen lassen und sich dadurch insbesondere die Verschleißbeständigkeit und die strukturelle Festigkeit der Beschichtung in einem weiten Bereich einstellen lässt. Es können dabei Aluminide bzw. intermetallische Verbindung gebildet werden, welche durch ihre globulare Form zu einer Verfestigung der Matrix führen.

Möglich ist auch das die Hartphase durch Silizium gebildet ist und/oder der Anteil an Silizium an der Legierung im Bereich zwischen 3 Gew.-% und 13,5 Gew.-%, insbesondere im Bereich zwischen 4 Gew.-% und 11,5 Gew.-%, beträgt, bzw. der Anteil an Silizium an der Legierung im Bereich zwischen 7,5 Gew.-% und 8,5 Gew.-% beträgt, wodurch der Vorteil entsteht, dass sich durch die harten Siliziumpartikel neben den Ermüdungseigenschaften auch die Antiblockiereigenschaften und die Verschleißbeständigkeit verbessern. Die Siliziumpartikel bzw. Siliziumkörner schleifen Kanten, Grate usw. der Oberfläche des Gleitpartners ab, wodurch die Beständigkeit gegenüber fressendem Verschleiß erhöht wird. Durch eine Zusammensetzung nahe des Eutektikums entsteht eine feine Verteilung der Siliziumpartikel, wodurch ein positiver Effekt im Hinblick auf die Zähigkeit und Festigkeit der Legierung bzw. der Beschichtung entsteht.

Möglich ist auch, dass die Hartphase zumindest durch Kupfer gebildet ist und der Anteil an Kupfer im Bereich zwischen 0,5 Gew.-% und 10 Gew.-%, insbesondere im Bereich zwischen 1 Gew.-% und 7 Gew.-%, beträgt, da dadurch eine höhere Festigkeit durch Mischkristallhärtung erreicht werden kann und die Ermüdungsbeständigkeit erhöht wird.

Dadurch, dass die Legierung durch 24 Gew.-% bis 26 Gew.-% Zinn, 7 Gew.-% bis 8 Gew.-% Silizium und den Rest Aluminium mit üblichen Verunreinigungen gebildet ist, wird eine Legierung bereitgestellt, welche ein gut abgestimmtes Eigenschaftsprofil hinsichtlich der tribologischen Verträglichkeit und der dabei erreichten mechanischen Belastbarkeit aufweist.

Der Anteil der Hartphase kann kleiner oder gleich dem Anteil der Weichphase sein, wodurch eine Versprödung der Legierung durch eine zu hohe Härte vermieden wird.

Nach einer Weiterbildung der Beschichtung ist auch möglich, dass die Beschichtung eine Dicke im Bereich zwischen 5 µm und 40 µm, bevorzugt im Bereich zwischen 10 µm und 25 µm, aufweist, wodurch die Dicke an die auftretenden Belastungen abgestimmt werden kann und somit ein optimaler Materialeinsatz erreicht werden kann.

Gemäß der Weiterbildung des Verbundwerkstoffs, wonach zwischen dem Träger und der Randschicht eine weitere Schicht als Diffusionssperre und/oder Haftschicht ausgebildet ist, kann auch bei unterschiedlichsten Schichtaufbauten, wie beispielsweise einer zur Stabilisierung angeordneten Stahlstützschicht, ein diffundieren von Atomen dieser beiden Schichten untereinander wirkungsvoll verhindert werden bzw. kann eine gute Haftung der erfindungsgemäßen Beschichtung erreicht werden.

Möglich ist, dass die weitere Schicht eine Dicke im Bereich zwischen 0,5 µm und 5 µm, bevorzugt im Bereich zwischen 1 µm und 3 µm, aufweist, wodurch eine hohe Haftfestigkeit der Schichten aufeinander erreicht werden kann bzw. abhängig von den Beschichtungselementen eine genügend große Diffusionsbarriere gebildet werden kann.

Gemäß einer Weiterbildung, wonach die weitere Schicht aus einem Reinmetall und/oder aus einer binären oder ternären Legierung eines Elements aus der ersten oder zweiten Elementgruppe gebildet wird, wird der Vorteil erzielt, dass klar definierte Eigenschaften erreicht werden und der Diffusionskoeffizient möglichst gering gehalten werden kann.

Durch der Weiterbildung des Verfahrens, wonach zwischen dem Träger und der Randschicht zunächst eine weitere Schicht als Diffusionssperre oder Haftschicht auf dem Träger abgeschieden wird, wird der Vorteil einer verbesserten Haftung der erfindungsgemäßen Beschichtung, beispielsweise auf einer metallischen Stützschichte als Träger erzielt bzw. wird ein Diffundieren von Atomen von der erfindungsgemäßen Beschichtung zur Stützschicht und umgekehrt verhindert.

Möglich ist, dass das Abscheiden aus der Gasphase mittels eines PVD Verfahrens durchgeführt wird, wodurch der Vorteil einer relativ geringen Temperaturbelastung des zu beschichtenden Bauteils erreicht wird, wodurch insbesondere auch dünnwandige Bauteile ohne Bauteilverzug beschichtet werden können.

Gemäß einer Weiterbildung, wonach das PVD Verfahren nach einem Sputterverfahren, insbesondere nach einem Gleichstrommagnetronsputterverfahren, durchgeführt wird, wird der Vorteil erreicht, dass hohe Depositionsraten erreicht werden, wodurch Zeit und somit Kosten eingespart werden können und zudem ein Planarisierungseffekt durch die angelegte elektrische Spannung eintritt, wodurch eine bessere Oberflächenqualität der Schicht erreicht wird.

Gemäß einer Weiterbildung, wonach die Prozesstemperatur weniger als 90% der Schmelztemperatur der Weichphase beträgt, wird der Vorteil erreicht, dass ein vollständiges Aufschmelzen der Weichphasenpartikel verhindert und zugleich eine hohe Haftfähigkeit der Partikel bei geringer Substratbelastung erreicht wird.

Wenn die Abscheiderate größer als 0,1 µm/min gewählt wird, ergibt sich der Vorteil, dass eine hohe Schichtqualität bei gleichzeitig ausreichend schneller und somit wirtschaftlicher Schichtherstellung erreicht wird.

Durch die Verwendung von Argon als Sputtergas kann der Sputtervorgang wirtschaftlich durchgeführt werden.

Die Erfindung umfasst weiters die Verwendung der Aluminiumlegierung zur Herstellung einer Gleitschicht für Gleitelemente, beispielsweise Gleitlager, Anlaufringe oder Büchsen oder zur Beschichtung von tribologisch beanspruchten Bauteilen, z.B. Wellen oder Pleuel.

Zum besseren Verständnis wird die Erfindung anhand der nachfolgenden Figuren näher erläutert.

Es zeigen in jeweils schematisch vereinfachter Darstellung:
- Fig. 1: einen schematischen Aufbau einer Sputteranlage;
- Fig. 2: schematisch die Häufigkeit und Verteilung der Partikel der Aluminiumlegierung;
- Fig. 3: ein Schliffbild einer Beschichtung aus einer möglichen Aluminiumlegierung.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen. Weiters können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

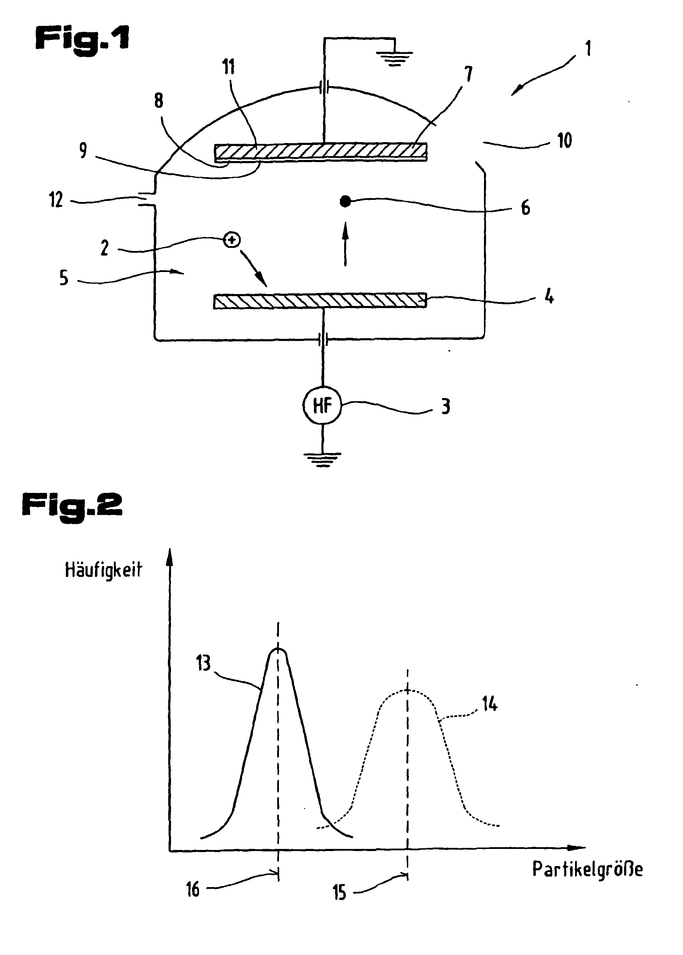

Fig. 1 zeigt einen schematischen Aufbau einer Sputteranlage 1. Die guten Eigenschaften der erfindungsgemäßen Aluminiumlegierung, insbesondere deren geringe Partikelgrößen, bzw. deren Verteilung, konnten überraschenderweise durch ein Abscheideverfahren aus der Gasphase erreicht werden.

Erfindungsgemäß ist es möglich, dass zur Abscheidung ein CVD- oder ein PVD-Verfahren verwendet wird.

Bei CVD-Verfahren (Chemical Vapour Deposition) wird das Schichtmaterial durch eine chemische Reaktion direkt an der Oberfläche der zu beschichtenden Teile aus gasförmigen Stoffen gebildet.

Einige Parameter, die die Abscheiderate sowie Zusammensetzung und Struktur der Schichten beeinflussen, sind: Zusammensetzung der Gasatmosphäre, Temperatur der zu beschichtenden Teile, Strömungsgeschwindigkeit des Beschichtungsgases sowie die Beschichtungsdauer.

Ein CVD-Verfahren birgt den Vorteil, dass eine Beschichtung auch von geometrisch komplexen Formen bzw. Körpern bzw. Trägern möglich ist.

Bei PVD-Verfahren wird die erfindungsgemäße Legierung durch physikalische Prozesse in die Gasphase übergeführt und scheidet sich dann durch Kondensation auf der Substratoberfläche ab. Die Beschichtung wird aus Ionen und Neutralteilchen aus einem Plasma gebildet und erfolgt die Einbringung der Legierung in das Plasma durch Verdampfung mit einem Elektronenstrahl oder einem Lichtbogen oder durch Kathodenzerstäubung.

Beim Verfahren der Kathodenzerstäubung werden Ionen 2 in einem elektrischen Hochfrequenzfeld einer entsprechenden Quelle 3 beschleunigt und auf eine Zielelektrode bzw. Target 4 gelenkt. Das Target 4 ist in solch einem Verfahren zugleich die Kathode.

Als Quelle der Ionen 2 dient ein ionisiertes Edelgas bzw. ein Plasma 5. Die beschleunigten Ionen 2 schlagen beim Auftreffen auf das Target 4, Atome 6 aus der Oberfläche des Targetmaterials heraus und bewegen sich diese mit hoher Geschwindigkeit in Richtung des Substrats 7 und schlagen sich dort als Beschichtung 8 nieder.

Es ist natürlich bei allen Verfahren möglich, eine Verdichtung der aufgebrachten Schicht durch eine Wärmebehandlung gleichzeitig mit dem Aufbringen durchzuführen.

Das Substrat 7 soll nicht auf die in Fig. 1 dargestellte Plattenform beschränkt sein, sondern können erfindungsgemäß auch davon abweichende Formen, beispielsweise Lagerhalbschalen oder auch Vollschalen, welche beispielsweise auch um ein entsprechend geformtes Taget 4 angeordnet sein können, verwendet werden.

Erfindungsgemäß kann die Beschichtung 8 eine Randschicht 9 eines Verbundwerkstoffes 10 bilden.

Das Substrat 7 kann einen Träger 11 des Verbundwerkstoffes 10 ausbilden. Der Träger 11 kann beispielsweise durch eine Stahlschicht oder ähnliche geeignete Werkstoffe gebildet sein. Möglich ist auch, dass der Träger 11 durch ein mehrschichtiges metallisches Substrat 7 gebildet ist.

Möglich ist auch (in Fig. 1 nicht dargestellt), dass zwischen der Randschicht 9 und dem Träger 11 eine weitere Schicht, beispielsweise als Diffusionssperre oder Haftschicht ausgebildet ist, beispielsweise eine Schicht aus einer Bleibronze oder aus Reinmetallen.

Als Beispiel eines möglichen Lageraufbaues sei stellvertretend für eine Vielzahl an Möglichkeiten ein Lager mit AlSn25Si7,5 Laufschicht genannt. Der Träger 11 kann durch eine Stahlstützschale und einer CuPb20Sn2 Lagermetallschicht gebildet sein. Als weitere Schicht ist eine Ni Zwischenschicht als Diffusionssperre und Haftschicht angeordnet. Auf der Ni Schicht ist die erfindungsgemäße Beschichtung 8 als Randschicht 9 aufgebracht.

Hinsichtlich der Lagermetallschicht sei angemerkt, dass diese im Rahmen der Erfindung sowohl Blei enthaltend ausgebildet sein kann, also beispielsweise eine Bronze mit 10 Gew.-% Pb und 10 Gew.-% Sn, als auch vorteilhafterweise mit der erfindungsgemäßen Aluminiumlegierung bleifrei sei kann, also beispielsweise in Form von Kupfer-Zinn- bzw. Kupfer-Zink-Legierungen.

Es können mehrere Kanäle 12 angeordnet sein, durch welche beispielsweise Sputtergas zugeführt wird oder mittels derer ein Vakuum erzeugt wird.

Möglich ist ein Gleichstrommagnetronsputterverfahren wobei als Sputtergas Argon bei einem Druck von 5x10⁻³mbar verwendet werden kann.

Wichtige Parameter, die die Abscheiderate, Schichtzusammensetzung und -struktur beeinflussen, sind: Verdampfungsrate, Partialdruck eines Reaktionsgases, Substratspannung, Hilfsanodenspannung, Beschichtungstemperatur.

Gute Eigenschaften der Beschichtungen wurden beispielsweise auch bei Beschichtungsraten von ca. 0,75µm/min sowie einer Beschichtungstemperatur von 155°C erzielt.

Versuch haben gezeigt, dass sich mit einer erfindungsgemäßen A1Sn25Si7,5 Sputterschicht gegenüber einem Standard AlSn20Cu Sputterlager die Verreibgrenzlast um ca. 30% erhöhen ließ und eine stark erhöhte Verschleißfestigkeit bei spezifischen Lagerlasten über 100Mpa erreicht wurde.

Fig. 2 zeigt schematisch die Häufigkeit und Verteilung der Partikel der Aluminiumlegierung.

Dargestellt ist ein schematischer Verlauf 13 der Häufigkeit des Auftretens bestimmter Partikelgrößen der Hartphasen bzw. Weichphasen der erfindungsgemäßen Aluminiumlegierung.

Im Vergleich dazu zeigt ein Verlauf 14 die Häufigkeit des Auftretens bestimmter Partikelgrößen der Hartphasen bzw. Weichphasen einer entsprechenden Legierung nach dem Stand der Technik.

Es sei darauf hingewiesen, dass der Begriff "Partikel" bzw. Angaben zu deren Ausdehnung und Verteilung allgemein auf Weichphasen bzw. Hartphasen, insbesondere auch auf intermetallische Phasen, übertragen und entsprechend dem Sinngehalt umgelegt werden kann.

Der Begriff "Weichphase" beschreibt jene Partikel, welche der erfindungsgemäßen Legierung bzw. der Beschichtung 8 die Eigenschaften einer guten Anpassungsfähigkeit und Einbettfähigkeit für Fremdkörper verleihen und im Vergleich zu den Hartphasen, welche unter anderem für die hohe mechanische Stabilität und Dauerfestigkeit verantwortlich zeigen, eine deutlich geringere Härte aufweisen. Die Hartphasen weisen dabei eine höhere Härte als die reine Aluminiummatrix auf bzw. führen zu einer Härtesteigerung der Matrix.

Als Näherung kann angenommen kann, dass beide Verläufe 13, 14 einer Normalverteilung genügen, da die Abweichung von einem Mittelwert einer Vielzahl von einander unabhängigen Zufallsvariablen genügt.

Vorteilhaft bei der erfindungsgemäßen Aluminiumlegierung ist es, dass sie im Vergleich mit Legierungen aus dem Stand der Technik eine geringere mittlere Partikelgröße aufweisen.

Der Median 15 ist bei vergleichbaren Aluminiumlegierungen nach dem Stand der Technik zu größeren Partikel- bzw. Korngrößen hin verschoben.

Erfindungsgemäß weisen zumindest 80 %, vorzugsweise zumindest 90%, der Weichphasenpartikel einen mittleren Durchmesser von maximal 3 µm auf.

Der Median 16 liegt entsprechend einer angenommenen Normalverteilung darunter.

In vorteilhaften Ausgestaltungen der erfindungsgemäßen Aluminiumlegierung weisen zumindest 80 %, vorzugsweise zumindest 90 %, der Weichphasen bzw. Weichphasenpartikel einen mittleren Durchmesser von max. 2 µm, insbesondere von max. 1 µm, auf.

Es sei an dieser Stelle angemerkt, dass der in Fig. 1 dargestellte Verlauf 13 bzw. 14 nur die Gegebenheiten eines statistischen Prozesses wiederspiegelt, dessen Verläufe nur bei einer genügend großen, einer Auswertung zugrunde gelegten Grundgesamtheit, mit Messergebnissen übereinstimmt. Dem gemäß können Abweichungen bzw. Unsymmetrien in den tatsächlichen Verläufen möglich sein.

Der Unterschied der mittleren Partikelgrößen, zu denen aus dem Stand der Technik bekannten Legierungen, vergrößert sich, wenn die Weichphasen bzw. Weichphasenpartikel einen mittleren Durchmesser im Bereich von 200 nm bis 700 nm, insbesondere im Bereich von 350 nm bis 550 nm aufweisen. Durch diese geringen Größen kann das Eigenschaftsprofil der Aluminiumlegierung noch weiter verbessert werden.

Dargestellt ist weiters, dass die Häufigkeitsverteilung der Partikelgrößen der erfindungsgemäßen Aluminiumlegierung schmäler verläuft als bei Aluminiumlegierungen nach dem Stand der Technik. Durch diesen schmalen Verlauf 13 ergibt sich ein homogeneres Gefüge der Beschichtung 8, wodurch diese in ihren mechanischen Eigenschaften hinsichtlich der aufnehmbaren statischen und dynamischen Belastungen verbessert ist. Dadurch werden ebenfalls die Kennwerte einer Beschichtung 8 reproduzierbarer, wodurch bei strengen Spezifikationen die Ausschussmenge reduziert werden kann.

Der Verlauf 13 gilt im wesentlichen auch für die in der Aluminiummatrix dispergierten Hartphasenpartikel, wenn in einer vorteilhaften Ausgestaltung der Erfindung zumindest 90 %, vorzugsweise zumindest 95 %, der Hartphasenpartikel einen geringeren mittleren Durchmesser als die Weichphasenpartikel aufweisen.

Durch die geringere Partikelgröße der Weichphasen- bzw. Hartphasen der erfindungsgemä-ßen Aluminiumlegierung wird trotz eines hohen Weichphasenanteiles zum Erreichen guter tribologischer Verträglichkeit, eine hohe mechanische Belastbarkeit der Beschichtung 8 erzielt. Zusätzlich ergibt sich der Vorteil einer verringerten Kerbwirkung einzelner Hartphasen, beispielsweise Silizium.

Es wird eine hohe Härte der Beschichtung 8 erreicht und gleichzeitig eine Versprödung vermieden wodurch sich Vorteile in den mechanischen Eigenschaften gegenüber aus dem Stand der Technik bekannten Legierungen ergeben.

Möglich ist, dass die Beschichtung 8 eine Härte im Bereich zwischen 115 HV 0,001 und 150 HV 0,001 , insbesondere zwischen 120 HV 0,001 und 145 HV 0,001 , aufweist, wodurch eine hohe Festigkeit und hohe mechanische Stabilität der Schicht, insbesondere gegenüber hohen statischen Belastungen erreicht wird.

Die nachfolgende Tabelle zeigt einige Ausführungsvarianten der Aluminiumlegierung, wobei die Zahlenangaben in Gew.-% bezogen auf die Aluminiumlegierung zu verstehen sind.

| | **Sn** | **Si** | **Cu** | **Mn** | **Mg** | **Cr** | **Co** | **Zr** | **Zn** | **Fe** | **Ni** | **Al** |
|---|---|---|---|---|---|---|---|---|---|---|---|---|
| **1** | 18,5 | 0,2 | 1,5 | 0,15 | - | - | 0,25 | - | - | - | 0,75 | Rest |
| **2** | 18 | 7,5 | - | 0,35 | - | - | 0,5 | - | - | 0,6 | 0,65 | Rest |
| **3** | 25 | 7,5 | - | - | - | - | - | - | - | - | - | Rest |
| **4** | 24,5 | 7,5 | - | - | - | - | - | - | - | 0,15 | - | Rest |
| **5** | 30 | 7,5 | - | - | - | - | - | - | - | 0,15 | - | Rest |
| **6** | 24,5 | 14,5 | - | - | - | - | - | - | - | 0,15 | - | Rest |
| **7** | 30 | 14,5 | - | - | - | - | - | - | - | 0,15 | - | Rest |
| **8** | 24,5 | - | 1,2 | 0,5 | - | 0,1 | 0,1 | 0,1 | - | 0,15 | - | Rest |
| **9** | 23 | <0,2 | 1,1 | 0,4 | - | 0,05 | 0,05 | 0,05 | - | 0,05 | - | Rest |
| **10** | 27 | <0,2 | 1,85 | 0,8 | - | 0,15 | 0,15 | 0,15 | - | 0,25 | - | Rest |
| **11** | 25 | 1,5 | 1,0 | - | 1,0 | - | - | 0,1 | 4,5 | - | - | Rest |
| **12** | 25 | 12 | 0,5 | - | 1,0 | - | - | - | - | - | - | Rest |
| **13** | 25 | 7,5 | 1 | - | 1 | - | - | - | - | - | 1 | Rest |
| **14** | 25 | 3,5 | 1 | - | 1 | - | - | - | - | - | 1 | Rest |
| **15** | 24,5 | - | 1,2 | 0,5 | - | - | 0,1 | 0,1 | - | 0,15 | - | Rest |

| | **Sn** | **Si** | **Cu** | **Ca** | **Au** | **W** | **V** | **Ag** | **Sc** | **Nb** | **Mo** | **Al** |
|---|---|---|---|---|---|---|---|---|---|---|---|---|
| **16** | 15 | 10 | 1,1 | - | - | 1,5 | - | - | 0,5 | 1 | - | Rest |
| **17** | 40 | - | 2,5 | - | - | 2 | - | - | 2 | 1,34 | 0,45 | Rest |
| **18** | 18,5 | 2,2 | 0,95 | - | - | 1,1 | - | - | 3,4 | 2 | - | Rest |
| **19** | 22 | - | 4 | - | - | - | - | 0,55 | 1 | 3,4 | - | Rest |
| **20** | 21,3 | - | 2,2 | - | - | - | - | 1,2 | - | 1 | - | Rest |
| **21** | 31,5 | - | 2,2 | 15,1 | - | - | 1,5 | - | - | - | - | Rest |
| **22** | 17 | - | - | - | - | - | 2,21 | 2 | 3,75 | 0,45 | - | Rest |
| **23** | 19 | 3,4 | - | - | - | - | 2,2 | 1,1 | 1 | 1,1 | - | Rest |
| **24** | 22 | 8 | - | - | - | - | 3 | 0,9 | 0,25 | 0,75 | - | Rest |
| **25** | 23,5 | 11 | - | - | - | - | 2,4 | 0,8 | 0,21 | - | - | Rest |
| **26** | 25 | 4,5 | - | - | - | - | 0,45 | 1 | 1 | - | - | Rest |
| **27** | 26 | - | - | - | 1,21 | 1,23 | - | - | - | - | - | Rest |
| **28** | 21,5 | - | - | 2,4 | - | - | - | - | - | - | - | Rest |
| **29** | 22 | - | 2,3 | - | 0,35 | - | - | - | - | 3,4 | - | Rest |
| **30** | 35 | - | 3,7 | - | - | - | 2,5 | 1,15 | - | - | 1,75 | Rest |
| **31** | 41 | - | 5,6 | - | - | - | 2,3 | - | - | 2,45 | 3,2 | Rest |
| **32** | 28 | - | 2,5 | - | - | 2,4 | - | - | - | 1 | 0,9 | Rest |
| **33** | 28 | 4,5 | - | 1 | - | 0,65 | - | - | 4,4 | 1 | - | Rest |

Auszugsweise seien einige vorteilhafte Eigenschaften einiger der in der Tabelle angeführten Legierungen genannt:
Nr. 3, 4: Zusammensetzung der AlSi-Matrix liegt nahe dem Eutektikum, daher wird ein besonders feinkörniges Gefüge erreicht. Es ergeben sich daher gute mechanische Eigenschaften.
Nr. 6: ebenfalls feinkörniges Gefüge, verbesserte tribologische Eigenschaften gegenüber 3 oder 4.
Nr. 9: geringer Anteil an Weihphase, gute mechanische Eigenschaften.
Nr. 10: gute Matrixfestigkeit.
Nr.11: hohe Matrixfestigkeit, Selbstaushärtungseffekt.
Nr. 12: Aushärteeffekt durch eine Mg₂Si Phase.

Die angeführten Aluminiumlegierungen sind nur als Beispiele für eine Vielzahl von anderen Legierungen, die in dieser Beschreibung nicht sämtliche dargestellt werden können, um den Umfang vorliegender Beschreibung nicht zu sprengen, genannt und sind nicht limitierend auf den Schutzbereich der Erfindung zu sehen. Der Fachmann auf diesem Gebiet ist aufgrund gegenständlicher Lehre in der Lage, Aluminiumlegierungen mit weiteren Elementkombinationen in den angegebenen Grenzen herzustellen und sind diese Zusammensetzungen nicht vom Schutzbereich ausgeschlossen. Insbesondere betrifft dies auch die beanspruchten Elementkombinationen, für die in den obigen Tabellen keine Beispiele angegeben sind, wie z.B. Bi, C, In, Pb, Pd, Pt, Y, Ce, Pr, Nd, Sm, Eu, Gd, Tb, Dy, Ho, Er, Tm, Yb, Lu, die für sich oder in Kombination miteinander bzw. den weiteren in den Ansprüchen bzw. obigen Tabellen angeführten Elementen im Umfang der in den Ansprüchen angegebenen Anteile in der erfindungsgemäßen Legierung vorhanden sein können.

Erfindungsgemäß ist es möglich, dass der Weichphasenanteil zwischen 15 Gew.-% und 45 Gew.-%, bevorzugt zwischen 20 Gew.-% und 40 Gew-%, beträgt, wodurch die Fressneigung reduziert werden kann.

Möglich ist auch, dass die Hartphase durch Silizium gebildet ist und der Anteil an der Legierung im Bereich zwischen 3 Gew.-% und 13,5 Gew.-%, bevorzugt im Bereich zwischen 4 Gew-% und 11,5 Gew-%, beträgt. Durch die Siliziumzugabe wird der Widerstand gegen Abrieb und die Ermüdungsfestigkeit erhöht. Silizium liegt dispergiert in der Aluminiummatrix vor und kann durch seine hohe Härte als Verstärkung der Aluminiummatrix wirken und ist zugleich durch die hohe thermische Stabilität des Siliziums auch bei hoher Temperaturbelastung dessen Wirkung gegeben.

Die Hartphase kann auch erfindungsgemäß mit einem Anteil im Bereich zwischen 1,5 Gew-% und 40 Gew-%, oder im Bereich zwischen 2 Gew-% und 20 Gew-%, insbesondere im Bereich zwischen 2,5 Gew-% und 17 Gew-%, in der Legierung enthalten sein und durch Elemente bzw. durch intermetallische Phasen aus Aluminium und Elementen aus einer ersten Elementgruppe umfassend Chrom, Eisen, Kobalt, Kupfer, Mangan, Nickel, Molybdän, Magnesium, Niob, Platin, Scandium, Silber, Silizium, Vanadium, Wolfram, Zirkonium und/oder Carbide, Silicide, Nitride, Boride der Elemente der ersten Elementgruppe bzw. durch intermetallische Phasen aus Elementen der ersten Elementgruppe gebildet werden.

Durch die Bildung intermetallischer Phasen werden die mechanischen Eigenschaften, beispielsweise die Festigkeit oder die Ermüdungsfestigkeit, erhöht.

Es können erfindungemäß auch mehrere Elemente dieser ersten Elementgruppe der Aluminiumlegierung zugegeben werden, wodurch sich deren Eigenschaften gezielt einstellen lassen.

So wirken beispielsweise Kupfer und Magnesium matrixverstärkend, ohne die Duktilität des Materials zu verschlechtern. Zusätzlich wird die Ermüdungsbeständigkeit erhöht.

Chrom, Mangan, Kobalt und Eisen steigern die Härte und dadurch die mechanische Festigkeit durch Bildung intermetallischer Phasen mit Aluminium.

Mangan erhöht neben der Festigkeit auch die Korrosionsbeständigkeit.

Durch die Zugabe von Zirkonium und/oder Nickel können intermetallische Verbindungen gebildet werden, welche die Ermüdungsbeständigkeit der Beschichtung verbessern.

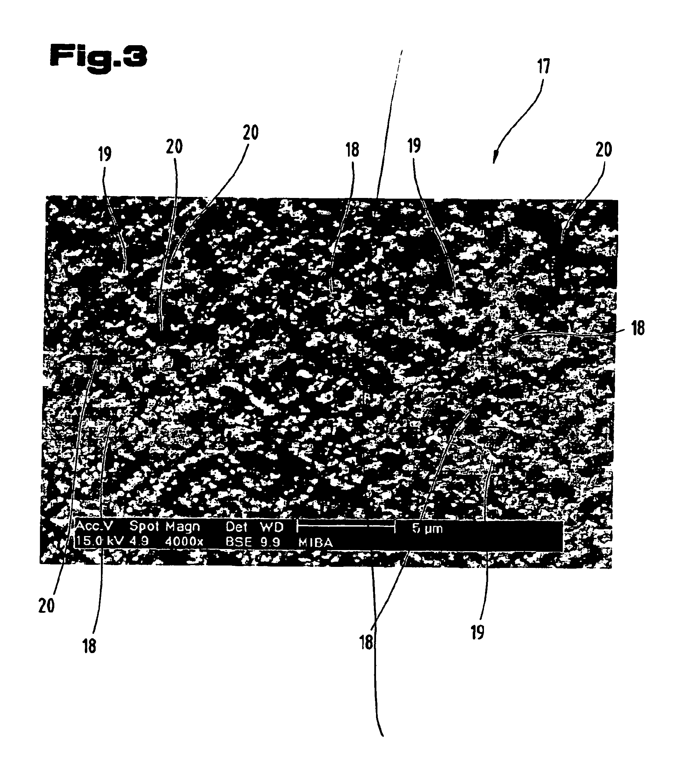

Fig. 3 zeigt ein Schliffbild 17 einer Beschichtung 8 aus einer möglichen Aluminiumlegierung, wobei als Weichphase Zinn und als Hartphase im wesentlichen Silizium enthalten ist.

Enthalten sind ungefähr 7,5 Gew.- % Silizium, 18 Gew-% Zinn und einige weitere Elemente wie Mangan, Eisen, Kobalt und Nickel, deren Anteile in Summe aber unter zwei Gew-% liegen und für die Aussage der Fig. 3 vernachlässigt werden können.

Aus dem Schliffbild 17 geht hervor, dass sowohl Weichphasen- 18 (mittlere Helligkeit) als auch die Hartphasenpartikel 19 (helle Bereiche) feindispers und im wesentlichen globular in einer Aluminiummatrix 20 (dunkle Bereiche) vorliegen. Der Anteil an Agglomeraten ist gering und führt daher zu keiner Verschlechterung der Eigenschaften der Beschichtung 8.

Insgesamt ergeben sich dadurch die bereits genannten Vorteile in den mechanischen und tribologischen Eigenschaften der erfindungsgemäßen Beschichtung 8.

Die Vergrößerung bzw. der Maßstab des Schliffbildes 17 ist am unteren Rand der Fig. 3 zu entnehmen.

Die Ausführungsbeispiele zeigen mögliche Ausführungsvarianten der Legierung und der Beschichtung 8, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt. Es sind also auch sämtliche denkbaren Ausführungsvarianten, die durch Kombinationen einzelner Details der dargestellten und beschriebenen Ausführungsvariante möglich sind, vom Schutzumfang mitumfasst.

Der Ordnung halber sei abschließend darauf hingewiesen, dass zum besseren Verständnis des Aufbaus der Beschichtung 8 und der Sputteranlage 1 diese bzw. deren Bestandteile teilweise unmaßstäblich und/oder vergrößert und/oder verkleinert dargestellt wurden.

Die den eigenständigen erfinderischen Lösungen zugrunde liegende Aufgabe kann der Beschreibung entnommen werden.

Vor allem können die einzelnen in den Fig. 1; 2; 3 gezeigten Ausführungen den Gegenstand von eigenständigen, erfindungsgemäßen Lösungen bilden. Die diesbezüglichen erfindungsgemäßen Aufgaben und Lösungen sind den Detailbeschreibungen dieser Figuren zu entnehmen.

### Bezugszeichenaufstellung

- 1: Sputteranlage
- 2: Ionen
- 3: Quelle
- 4: Target
- 5: Plasma

- 6: Atom
- 7: Substrat
- 8: Beschichtung
- 9: Randschicht
- 10: Verbundwerkstoff

- 11: Träger
- 12: Kanal
- 13: Verlauf
- 14: Verlauf
- 15: Median

- 16: Median
- 17: Schliffbild
- 18: Weichphasenpartikel
- 19: Hartphasenpartikel
- 20: Aluminiummatrix

## Patentansprüche

1. Aluminiumlegierung für eine Beschichtung für tribologisch beanspruchte Flächen, mit einer Aluminiummatrix (20) in der zumindest eine Weichphase und Hartphase eingelagert ist, wobei die Hartphase durch zumindest ein Element aus einer ersten Elementgruppe umfassend Chrom, Eisen, Kobalt, Kupfer, Mangan, Nickel, Molybdän, Magnesium, Niob, Platin, Scandium, Silber, Silizium, Vanadium, Wolfram, Zirkonium und/- oder Carbide, Silicide, Nitride, Boride der Elemente der ersten Elementgruppe bzw. durch intermetallische Phasen aus Elementen der ersten Elementgruppe und/oder durch intermetallische Phasen aus Aluminium mit den Elementen aus der ersten Elementgruppe, und die Weichphase durch zumindest ein Element aus einer zweiten Elementgruppe, umfassend Silber, Aluminium, Gold, Bismut, Kohlenstoff (Graphit), Kalzium, Kupfer, Indium, Magnesium, Blei, Palladium, Platin, Scandium, Zinn, Yttrium, Zink und die Lanthanoide gebildet ist, wobei das Weichphasenelement ungleich dem Hartphasenelement ist, **dadurch gekennzeichnet, dass** die Weichphase und/oder die Hartphase in der Aluminiummatrix (20) im wesentlichen fein verteilt vorliegt und zumindest 80 %, vorzugsweise zumindest 90 %, der Weichphase bzw. der Weichphasenpartikel (18) einen mittleren Durchmesser von maximal 3 µm aufweist und dass zumindest 90 % der Hartphasen bzw. der Hartphasenpartikel (19) einen geringeren mittleren Durchmesser als die Weichphasenpartikel (18) aufweisen, wobei der mittlere Durchmesser der Hartphase bzw. Hartphasenpartikel maximal 50% des mittleren Durchmessers der Weichphase bzw. Weichphasenpartikel beträgt.

2. Aluminiumlegierung nach Anspruch 1, **dadurch gekennzeichnet, dass** die Weichphasen bzw. die Weichphasenpartikel (18) einen mittleren Durchmesser von maximal 2 µm, insbesondere maximal 1µm, aufweisen.

3. Aluminiumlegierung nach Anspruch 1, **dadurch gekennzeichnet, dass** die Weichphasen bzw. die Weichphasenpartikel (18) einen mittleren Durchmesser im Bereich von 200 nm bis 700 nm, insbesondere im Bereich von 350 nm bis 550 nm, aufweisen.

4. Aluminiumlegierung nach einem der Ansprüche 1 bis 3, **dadurch gekennzeichnet, dass** zumindest 95 % der Hartphasen bzw. der Hartphasenpartikel (19) einen geringeren mittleren Durchmesser als die Weichphasenpartikel (18) aufweisen.

5. Aluminiumlegierung nach Anspruch 4, **dadurch gekennzeichnet, dass** der mittlere Durchmesser der Hartphasen bzw. Hartphasenpartikel (19) maximal 25 %, des mittleren Durchmessers der Weichphasen bzw. Weichphasenpartikel (18) beträgt.

6. Aluminiumlegierung nach einem der Ansprüche 1 bis 5, **dadurch gekennzeichnet, dass** der Anteil der Weichphase im Bereich zwischen 15 Gew.-% und 45 Gew-%, bevorzugt im Bereich zwischen 20 Gew-% und 40 Gew-%, beträgt.

7. Aluminiumlegierung nach einem der Ansprüche 1 bis 5, **dadurch gekennzeichnet, dass** der Anteil der Weichphase im Bereich zwischen 23 Gew-% und 28 Gew-% beträgt.

8. Aluminiumlegierung nach einem der vorhergehenden Ansprüche, **dadurch gekennzeichnet, dass** der Anteil der Hartphase im Bereich zwischen 1,5 Gew-% und 40 Gew-% beträgt.

9. Aluminiumlegierung nach einem der vorhergehenden Ansprüche, **dadurch gekennzeichnet, dass** der Anteil der Hartphase im Bereich zwischen 2 Gew-% und 20 Gew-%, insbesondere im Bereich zwischen 2,5 Gew-% und 17 Gew-%, beträgt.

10. Aluminiumlegierung nach einem der vorhergehenden Ansprüche, **dadurch gekennzeichnet, dass** die Hartphase durch Silizium gebildet ist und/oder der Anteil an Silizium an der Legierung im Bereich zwischen 3 Gew-% und 13,5 Gew-%, bevorzugt im Bereich zwischen 4 Gew-% und 11,5 Gew-%, beträgt.

11. Aluminiumlegierung nach einem der vorhergehenden Ansprüche, **dadurch gekennzeichnet, dass** der Anteil an Silizium an der Legierung im Bereich zwischen 7,5 Gew-% und 8,5 Gew-% beträgt.

12. Aluminiumlegierung nach einem der vorhergehenden Ansprüche, **dadurch gekennzeichnet, dass** die Hartphase zumindest durch Kupfer gebildet ist und der Anteil an Kupfer im Bereich zwischen 0,5 Gew-% und 10 Gew-%, insbesondere im Bereich zwischen 1 Gew-% und 7 Gew-%, beträgt.

13. Aluminiumlegierung nach einem der vorhergehenden Ansprüche, **dadurch gekennzeichnet, dass** die Legierung durch 24 Gew-% bis 26 Gew-% Zinn, 7 Gew-% bis 8 Gew-% Silizium und den Rest Aluminium mit üblichen Verunreinigungen gebildet ist.

14. Aluminiumlegierung nach einem der vorhergehenden Ansprüche, **dadurch gekennzeichnet, dass** der Anteil der Hartphase kleiner oder gleich dem Anteil der Weichphase ist.

15. Beschichtung (8), insbesondere für Gleitelemente, aus einer Aluminiumlegierung, **dadurch gekennzeichnet, dass** die Aluminiumlegierung nach einem oder mehreren der vorhergehenden Ansprüche gebildet ist.

16. Beschichtung (8) nach Anspruch 15, **dadurch gekennzeichnet, dass** die Beschichtung (8) eine Dicke im Bereich zwischen 5 µm und 40 µm, bevorzugt im Bereich zwischen 10 µm und 25 µm, aufweist.

17. Verbundwerkstoff (10) aus zumindest einem Träger (11) und einer darauf angeordneten Randschicht (9), **dadurch gekennzeichnet, dass** die Randschicht (9) durch eine Beschichtung (8) nach Anspruch 15 oder 16 gebildet ist.

18. Verbundwerkstoff (10) nach Anspruch 17, **dadurch gekennzeichnet, dass** zwischen dem Träger (11) und der Randschicht (9) eine weitere Schicht als Diffusionssperre und/oder Haftschicht ausgebildet ist.

19. Verbundwerkstoff (10) nach Anspruch 17 oder 18, **dadurch gekennzeichnet, dass** die weitere Schicht eine Dicke im Bereich zwischen 0,5 µm und 5 µm, bevorzugt im Bereich zwischen 1 µm und 3 µm, aufweist.

20. Verbundwerkstoff (10) nach Anspruch 18 oder 19, **dadurch gekennzeichnet, dass** die weitere Schicht aus einem Reinmetall und/oder aus einer binären oder ternären Legierung eines Elements aus der ersten oder zweiten Elementgruppe gebildet wird.

21. Verfahren zur Herstellung eines Verbundwerkstoffes (10) aus zumindest einem Träger (11) und einer darauf angeordneten Randschicht (9), **dadurch gekennzeichnet, dass** durch ein Abscheiden aus einer Gasphase auf dem Träger (11), als Randschicht (9) eine Aluminiumlegierung nach einem der Ansprüche 1 bis 14 hergestellt wird.

22. Verfahren nach Anspruch 21, **dadurch gekennzeichnet, dass** zwischen dem Träger (11) und der Randschicht (9) zunächst eine weitere Schicht als Diffusionssperre oder Haftschicht auf dem Träger (11) abgeschieden wird.

23. Verfahren nach Anspruch 21 oder 22, **dadurch gekennzeichnet, dass** das Abscheiden aus der Gasphase mittels eines PVD Verfahrens durchgeführt wird.

24. Verfahren nach Anspruch 23, **dadurch gekennzeichnet, dass** das PVD Verfahren nach einem Sputterverfahren, insbesondere einem Gleichstrommagnetronsputterverfahren, durchgeführt wird.

25. Verfahren nach einem der Ansprüche 21 bis 24, **dadurch gekennzeichnet, dass** die Beschichtungstemperatur weniger als 90% der Schmelztemperatur der Weichphase beträgt.

26. Verfahren nach einem der Ansprüche 21 bis 25, **dadurch gekennzeichnet, dass** die Abscheiderate größer als 0,1 µm/min gewählt wird.

27. Verfahren nach einem der Ansprüche 21 bis 26, **dadurch gekennzeichnet, dass** als Sputtergas Argon verwendet wird.

28. Verwendung der Aluminiumlegierung nach einem der Ansprüche 1 bis 14 zur Herstellung einer Gleitschicht für Gleitelemente, beispielsweise Gleitlager, Anlaufringe oder Büchsen.

29. Verwendung der Aluminiumlegierung nach einem der Ansprüche 1 bis 14 zur Beschichtung von tribologisch beanspruchten Bauteilen, beispielsweise Wellen oder Pleuel.

## Claims

1. Aluminium alloy with an aluminium matrix (20) for providing a protective coating for surfaces which are subjected to extreme stress due to friction incorporating at least a soft phase and a hard phase, which hard phase is made up of at least one element from a first group of elements comprising chromium, iron, cobalt, copper, manganese, nickel, molybdenum, magnesium, niobium, platinum, scandium, silver, silicon, vanadium, tungsten, zirconium and/or carbides, silicides, nitrides, borides of the elements of the first element group or inter-metallic phases from elements of the first element group and/or inter-metallic phases of aluminium incorporating elements from the first element group, and the soft phase is made up of at least one element from a second group of elements comprising silver, aluminium, gold, bismuth, carbon (graphite), calcium, copper, indium, magnesium, lead, palladium, platinum, scandium, tin, yttrium, zinc and lanthanoids, the soft phase element being different from the hard phase element, **characterised in that** the soft phase and/or the hard phase is essentially finely distributed in the aluminium matrix (20) and at least 80%, preferably 90%, of the soft phase or soft phase particles (18) have a mean diameter of a maximum of 3µm and at least 90% of the hard phases or hard phase particles (19) have a smaller mean diameter than the soft phase particles (18), whereas the mean diameter of the hard phases or hard phase particles (19) is a maximum of 50% of the mean diameter of the soft phases or soft phase particles (18).

2. Aluminium alloy as claimed in claim 1, **characterised in that** the soft phases or the soft phase particles (18) have a mean diameter of a maximum of 2 µm, in particular 1µm.

3. Aluminium alloy as claimed in claim 1, **characterised in that** the soft phases or the soft phase particles (18) have a mean diameter in the range of 200 nm to 700 nm, in particular in the range of from 350 nm to 550 nm.

4. Aluminium alloy as claimed in claims 1 to 3, **characterised in that** at least 95% of the hard phases or hard phase particles (19) have a smaller mean diameter than the soft phase particles (18).

5. Aluminium alloy as claimed in claim 4, **characterised in that** the mean diameter of the hard phases or hard phase particles (19) is a maximum of 25% of the mean diameter of the soft phases or soft phase particles (18).

6. Aluminium alloy as claimed in one of claims 1 to 5, **characterised in that** the proportion of soft phase is in the range of between 15 % by weight and 45% by weight, preferably in the range of between 20 % by weight and 40% by weight.

7. Aluminium alloy as claimed in one of claims 1 to 5, **characterised in that** the proportion of soft phase is in the range of between 23 % by weight and 28% by weight.

8. Aluminium alloy as claimed in one of the preceding claims, **characterised in that** the proportion of hard phase is in the range of between 1.5 % by weight and 40 % by weight.

9. Aluminium alloy as claimed in one of the preceding claims, **characterised in that** the proportion of hard phase is in the range of between 2 % by weight and 20 % by weight, in particular in the range of between 2.5 % by weight and 17% by weight.

10. Aluminium alloy as claimed in one of the preceding claims, **characterised in that** the hard phase contains silicon and /or the proportion of silicon in the alloy is in the range of between 3 % by weight and 13.5 % by weight, preferably in the range of between 4 % by weight and 11.5 % by weight.

11. Aluminium alloy as claimed in one of the preceding claims, **characterised in that** the proportion of silicon in the alloy is in the range of between 7.5 % by weight and 8.5 % by weight.

12. Aluminium alloy as claimed in one of the preceding claims, **characterised in that** the hard phase contains copper and the proportion of copper is in the range of between 0.5 % by weight and 10 % by weight, in particular in the range of between 1 % by weight and 7 % by weight.

13. Aluminium alloy as claimed in one of claims 1 to 10, **characterised in that** the alloy is made up of 24 % by weight to 26 % by weight of tin, 7 % by weight to 8 % by weight of silicon and the balance is aluminium and the usual impurities.

14. Aluminium alloy as claimed in one of the preceding claims, **characterised in that** the proportion of hard phase is smaller than or equal to the proportion of soft phase.

15. Coating (8), in particular for bearing elements, made from an aluminium alloy, **characterised in that** the aluminium alloy is as claimed in one or more of the preceding claims.

16. Coating (8) as claimed in claim 15, **characterised in that** the coating (8) has a thickness in the range of between 5 µm and 40 µm, preferably in the range of between 10 µm and 25 µm.

17. Composite material (10) comprising at least a base (11) and a surface layer (9) applied on top, **characterised in that** the surface layer (9) is a coating (8) as claimed in claim 15 or 16.

18. Composite material (10) as claimed in claim 17, **characterised in that** an additional layer is provided as a diffusion barrier and/or an adhesive layer between the base (11) and the surface layer (9).

19. Composite material (10) as claimed in claim 18, **characterised in that** the thickness of the additional layer is in the range of between 0.5 µm and 5 µm, preferably in the range of between 1 µm and 3 µm.

20. Composite material (10) as claimed in claim 18 or 19, **characterised in that** the additional layer is made from a pure metal and/or a binary or ternary alloy of an element from the first or second element group.

21. Process for the manufacture of a composite material (10) comprising at least a base (11) with a surface layer (9) applied on top, **characterised in that** an aluminium alloy as claimed in one of claims 1 to 14, which serves as a surface layer (9), is produced by a process of deposition on the base (11) from a gas phase.

22. Process as claimed in claim 21, **characterised in that** an additional layer is deposited on the base (11) between the base (11) and the surface layer (9) to act as a diffusion barrier or an adhesive layer.

23. Process as claimed in claim 21 or 22, **characterised in that** the deposition from the gas phase is achieved by means of a PVD process.

24. Process as claimed in claim 23, **characterised in that** the PVD process uses a sputtering technique, in particular a direct current magnetron sputtering process.

25. Process as claimed in one of claims 21 to 24, **characterised in that** the coating temperature is less than 90% of the melting temperature of the soft phase.

26. Process as claimed in one of claims 21 to 25, **characterised in that** the deposition rate is greater than 0.1 µm/min.

27. Process as claimed in one of claims 21 to 26, **characterised in that** argon is used as sputter gas.

28. Use of the aluminium alloy as claimed in one of claims 1 to 14 for the manufacture of a friction coating for friction components, for example friction bearings, thrust rings or bushes.

29. Use of the aluminium alloy as claimed in one of claims 1 to 14 for coating components which are subjected to extreme friction stress, for example shafts or rods.

## Revendications

1. Alliage d'aluminium pour le revêtement de surfaces chargées tribologiquement avec une matrice d'aluminium (20) dans laquelle sont incorporées au moins une phase molle et une phase dure, où la phase dure est formée pour au moins un élément d'un premier groupe d'éléments comprenant chrome, fer, cobalt, cuivre, manganèse, nickel, molybdène, magnésium, niobium, platine, scandium, argent, silicium, vanadium, tungstène, zirconium, et/ou carbures, siliciures, nitrures, borures, des éléments du premier groupe d'éléments respectivement, par des phases intermétalliques d'éléments du premier groupe d'éléments et/ou par des phases intermétalliques d'aluminium avec les éléments du premier groupe d'éléments et la phase molle est formée d'au moins un élément d'un second groupe d'éléments comprenant argent, aluminium, or, bismuth, carbone (graphite), calcium, cuivre, indium, magnésium, plomb, palladium, platine, scandium, étain, yttrium, zinc et les lanthanoïdes, où l'élément de la phase molle est différent de l'élément de la phase dure, **caractérisé en ce que** la phase molle et/ou la phase dure dans la matrice d'aluminium (20) est présente en étant finement répartie et au moins 80%, avantageusement au moins 90% de la phase molle où respectivement des particules de la phase molle (18) présentent un diamètre moyen qui est au maximum de 3µm et que au moins 90% des phases dures ou respectivement des particules de la phase dure (19) présentent un diamètre moyen plus petit que la particule de la phase molle (18), et que le diamètre moyen des phases dures ou respectivement des particules (19) de la phase dure est au maximum de 50% du diamètre moyen de la phase molle ou respectivement des particules de la phase molle (18).

2. Alliage aluminium selon la revendication 1, **caractérisé en ce que** les phases molles ou respectivement les particules de la phase molle (18) présentent un diamètre moyen qui est au maximum de 2µm, en particulier au maximum de 1 µm.

3. Alliage aluminium selon la revendication 1, **caractérisé en ce que** les phases molles ou respectivement les particules de phases molles (18) présentent un diamètre moyen compris entre 200 nm et 700 nm, en particulier entre 350 nm et 550 nm.

4. Alliage d'aluminium selon l'une quelconque des revendications 1 à 3, **caractérisé en ce qu'** au moins 95% des phases dures ou respectivement des particules de la phase dure (19) présentent un diamètre moyen plus petit que la particule de la phase molle (18).

5. Alliage d'aluminium selon la revendication 4, **caractérisé en ce que** le diamètre moyen des phases dures ou respectivement des particules (19) de la phase dure est au maximum de 25% du diamètre moyen de la phase molle ou respectivement des particules de la phase molle (18).

6. Alliage d'aluminium selon l'une quelconque des revendications 1 à 5, **caractérisé en ce que** la proportion de la phase molle est comprise entre 15% en poids et 45% en poids, avantageusement entre 20% en poids et 40% en poids.

7. Alliage d'aluminium selon l'une quelconque des revendications 1 à 5, **caractérisé en ce que** la proportion de la phase molle est comprise entre 23% en poids et 28% en poids.

8. Alliage d'aluminium selon l'une quelconque des revendications précédentes, **caractérisé en ce que** la proportion de la phase dure est comprise entre 1,5% en poids et 40% en poids.

9. Alliage d'aluminium selon l'une quelconque des revendications précédentes, **caractérisé en ce que** la proportion de la phase dure est comprise entre 2% en poids et 20% en poids, en particulier entre 2,5% en poids et 17% en poids.

10. Alliage d'aluminium selon l'une quelconque des revendications précédentes, **caractérisé en ce que** la phase dure est formée de silicium et/ou la proportion de silicium dans l'alliage est comprise entre 3% en poids et 13,5% en poids, et de préférence, entre 4% en poids et 11,5% en poids.

11. Alliage d'aluminium selon l'une quelconque des revendications précédentes, **caractérisé en ce que** la proportion de silicium dans l'alliage est comprise entre 7,5% en poids et 8,5% en poids.

12. Alliage d'aluminium selon l'une quelconque des revendications précédentes, **caractérisé en ce que** la phase dure est formée au moins de cuivre et la proportion du cuivre est comprise entre 0,5% en poids et 10% en poids, en particulier entre 1% en poids et 7% en poids.

13. Alliage d'aluminium selon l'une quelconque des revendications 1 à 10, **caractérisé en ce que** l'alliage est formé de 24% en poids à 26% en poids d'étain, de 7% en poids à 8% en poids de silicium, le reste étant de l'aluminium avec les impuretés habituelles.

14. Alliage d'aluminium selon l'une quelconque des revendications précédentes, **caractérisé en ce que** la proportion de la phase dure est plus petite ou égale à la proportion de la phase molle.

15. Revêtement (8), en particulier pour éléments glissants, en un alliage d'aluminium, **caractérisé en ce que** l'alliage d'aluminium est formé selon l'une quelconque des revendications précédentes.

16. Revêtement (8) selon la revendication 15, **caractérisé en ce que** le revêtement (8) présente une épaisseur comprise entre 5µm et 40µm, de préférence comprise entre 10µm et 25µm.

17. Matériau composite (10) formé au moins d'un support (11) et d'une couche superficielle (9) agencée par-dessus, **caractérisé en ce que** la couche superficielle (9) est formée d'un revêtement (8) selon la revendication 15 ou 16.

18. Matériau composite (10) selon la revendication 17, **caractérisé en ce qu'**entre le support (11) et la couche superficielle (9) est formée une autre couche en tant que barrage de diffusion et/ou couche de retenue.

19. Matériau composite (10) selon la revendication 18, **caractérisé en ce que** l'autre couche présente une épaisseur comprise entre 0,5µm et 5µm, avantageusement entre 1µm et 3µm.

20. Matériau composite (10) selon la revendication 18 ou 19, **caractérisé en ce que** l'autre couche est formée d'un métal pur et/ou d'un alliage binaire ou ternaire d'un élément du premier ou du second groupe d'éléments.

21. Procédé de production d'un matériau composite (10) formé au moins d'un support (11) et d'une couche superficielle (9) agencée par-dessus, **caractérisé en ce que**, par dépôt d'une phase gazeuse sur le support (11), on produit, en tant que couche superficielle (9), un alliage d'aluminium selon l'une quelconque des revendications 1 à 14.

22. Procédé selon la revendication 21, **caractérisé en ce qu'**entre le support (11) et la couche superficielle (9) est déposée au moins une autre couche en tant que barrage de diffusion ou couche de retenue sur le support (11).

23. Procédé selon la revendication 21 ou 22, **caractérisé en ce que** le dépôt se produit à partir de la phase gazeuse au moyen d'un procédé PVD.

24. Procédé selon la revendication 23, **caractérisé en ce que** le procédé PVD est accompli d'après un procédé de pulvérisation, en particulier un procédé de pulvérisation à magnétron à courant continu.

25. Procédé selon l'une quelconque des revendications 21 à 24, **caractérisé en ce que** la température de revêtement est plus petite que 90% de la température de fusion de la phase molle.

26. Procédé selon l'une quelconque des revendications 21 à 25, **caractérisé en ce que** la vitesse de dépôt est choisie plus importante que 0,1 µm/min.

27. Procédé selon l'une quelconque des revendications 21 à 26, **caractérisé en ce qu'**en tant que gaz de pulvérisation, on utilise de l'argon.

28. Utilisation de l'alliage d'aluminium selon l'une quelconque des revendications 1 à 14 pour la production d'une couche de glissement pour des éléments de glissement, par exemple des paliers à glissement, des anneaux d'usure ou des manchons.

29. Utilisation de l'alliage d'aluminium selon l'une quelconque des revendications 1 à 14 pour le revêtement de pièces chargées tribologiquement, par exemple des arbres ou des bielles.
